# FASCICULE DE BREVET EUROPEEN

(11) **EP 2 533 426 B1**
(45) Date de publication et mention de la délivrance du brevet: **26.10.2016**
(21) Numéro de dépôt: 12171554.4
(22) Date de dépôt: 11.06.2012
(51) Int. Cl.: H03M 1/18, H04L 27/00, G01S 19/21

(54) **Système de réception comprenant un mécanisme contre les interférences pulsées**
Empfangssystem, das mit einem Mechanismus gegen Pulsinterferenzen ausgestattet ist
Receiving system comprising a mechanism against pulsed interference

(30) Priorité: 10.06.2011 FR 1101781
(43) Date de publication de la demande: 12.12.2012
(73) Titulaire: THALES, 92400 Courbevoie (FR)
(72) Inventeur: Martin, Nicolas, 26500 BOURG LES VALENCE (FR); Perre, Jean-Michel, 07130 ST PERAY (FR); Depraz, David, 26000 VALENCE (FR)
(74) Mandataire: Brunelli, Gérald

(56) Documents cités:
- US-A1- 2006 176 985

## Description

L'invention concerne un système de réception comprenant un mécanisme contre les interférences pulsées. Elle s'applique notamment au domaine de la conversion numérique-analogique pour les radionavigation.

Dans un système de réception de radionavigation numériques, la démodulation des signaux est réalisée en numérique. Avant d'effectuer cette démodulation, un étage analogique du récepteur ramène le signal autour d'une fréquence intermédiaire. Cet étage analogique a également pour objectif d'amplifier le signal et de le filtrer à l'aide d'un filtre anti-repliement. Après filtrage, le signal est numérisé en utilisant un convertisseur analogique-numérique désigné habituellement par l'acronyme CAN. Afin d'asservir le gain de la chaîne analogique de façon à avoir un rendement maximal du convertisseur CAN, une boucle de contrôle adaptatif de gain CAG, appelée aussi boucle de contrôle automatique de gain, est habituellement utilisée.

En outre, pour certaines applications, le système de réception de radionavigation numériques doit prendre en compte le fait que les signaux analogiques reçus comportent un partie utile permettant d'obtenir des données numériques mais également des interférences. A titre d'exemple, il est prévu que les futurs systèmes de navigation par satellites GNSS, acronyme venant de l'expression anglo-saxonne « Global Navigation Satellite System », comme le GPS modernisé et le système Galileo utilisent des bandes de fréquence déjà utilisées pour l'aviation civile. Par exemple, la bande L5 permet de recevoir les fréquences des systèmes VOR/DME, acronyme venant de l'expression anglo-saxonne « Very Omni-Range / Distance Measurement Equipement ». Sur ces fréquences sont donc introduites des interférences pouvant affecter le bon fonctionnement de systèmes de réception de signaux GNSS. Ces interférences sont constituées pas des pulses de courte durée mais puissants et fréquents et sont de nature à empêcher une bonne réception des signaux GNSS.

Afin de réduire l'impact de ces interférences, une technique connue de suppression d'interférences désignée habituellement par le mot anglais « blanking » peut être utilisée. Cette technique consiste en une mise à zéro du signal reçu lorsqu'un niveau de puissance trop important est détectée. Ce niveau de puissance traduit la présence de pulses d'interférence appelés aussi interférences pulsées. Après suppression, il ne reste que les portions du signal reçu sans interférences pulsées, lesdites portions étant normalement suffisantes pour démoduler le signal GNSS et permettre la navigation. Dans la suite de la description, il est fait référence à cette technique en utilisant l'expression française « annulation temporaire de signal ».

Afin de mettre en oeuvre la technique d'annulation temporaire de signal, il faut choisir un seuil fixe sur le niveau de puissance estimé au delà duquel le signal est annulé. Le rôle de la boucle CAG est alors de maintenir un niveau de signal optimal par rapport à ce seuil. La boucle CAG utilise habituellement en entrée une mesure de puissance, voir par exemple US 2006/0176985 A1. Lorsque la technique d'annulation temporaire de signal est utilisée, la mesure de puissance pour la boucle CAG est habituellement mise en oeuvre après ce traitement. Ainsi, la mesure de puissance n'est pas perturbée par les interférences.

Un inconvénient est que le système de réception peut diverger en présence d'inférences. En effet, lorsque les interférences entrainant une annulation du signal sont nombreuses, la puissance moyenne mesurée en entrée de la boucle CAG diminue artificiellement. Cela a pour conséquence de faire réagir la boucle CAG, ladite boucle augmentant la valeur du gain analogique *gₐ* utilisé pour contrôler la puissance du signal en entrée du convertisseur CAN. L'amplitude du signal en entrée du module chargé de mettre en oeuvre l'annulation temporaire de signal est alors plus importante par rapport au seuil d'annulation prédéfini. Le signal reçu est alors mis à zéro encore plus fréquemment et la boucle de CAG diverge rendant impossible la démodulation du signal de radio-navigation.

Un but de l'invention est notamment de pallier les inconvénients précités.

A cet effet l'invention a pour objet un système de réception d'un signal analogique *e.* Le système comprend des moyens pour amplifier et numériser ledit signal afin d'obtenir un signal numérisé *eₙ*, un module d'inversion de puissance, ledit module déterminant un gain d'inversion *g₂*, ce gain étant appliqué au signal numérisé *eₙ*, une boucle de contrôle automatique de gain CAG adaptant la puissance du signal e avant numérisation. Le signal d'entrée de la boucle CAG est fonction du gain d'inversion *g₂*.

Dans un mode de réalisation, le signal d'entrée de la boucle CAG est le signal *eᵢ* obtenu après application du gain d'inversion *g₂*.

Dans un autre mode de réalisation, le signal d'entrée de la boucle CAG est le gain d'inversion de puissance *g₂* déterminé par le module d'inversion.

Le système est par exemple adapté pour recevoir des signaux satellites de type GNSS.

Selon un aspect de l'invention, le module d'inversion estime la puissance du signal numérisé *en,* filtre la puissance estimée, inverse la puissance estimée filtrée afin d'obtenir le gain *g₂* appliqué au signal numérisé *eₙ*.

Selon un autre aspect de l'invention, le gain d'inversion *g₂* est appliqué à une version retardé du signal numérisé *en,* ledit signal étant retardé afin de compenser le retard introduit par le filtrage.

La relation d'inversion entre la puissance estimé filtrée du signal numérisé *en* et le gain d'inversion *g₂* peut diffèrer selon les valeurs mesurées de la puissance *eₙ*.

Dans un mode de réalisation, pour une première plage de valeurs de puissance, un premier profil de gain d'inversion *g₂* est utilisé et pour une seconde plage de valeurs de puissance, un second profil de gain d'inversion *g₂* est utilisé.

D'autres caractéristiques et avantages de l'invention apparaîtront à l'aide de la description qui suit donnée à titre illustratif et non limitatif, faite en regard des dessins annexés parmi lesquels :
- la figure 1 présente un premier mode de réalisation du système de réception selon l'invention ;
- la figure 2 présente un second mode de réalisation du système de réception selon l'invention ;
- la figure 3 illustre la manière dont le gain d'inversion *g₂* peut être déterminé ;
- la figure 4 présente des exemples de mesures de la puissance instantanée avant et après inversion de puissance.

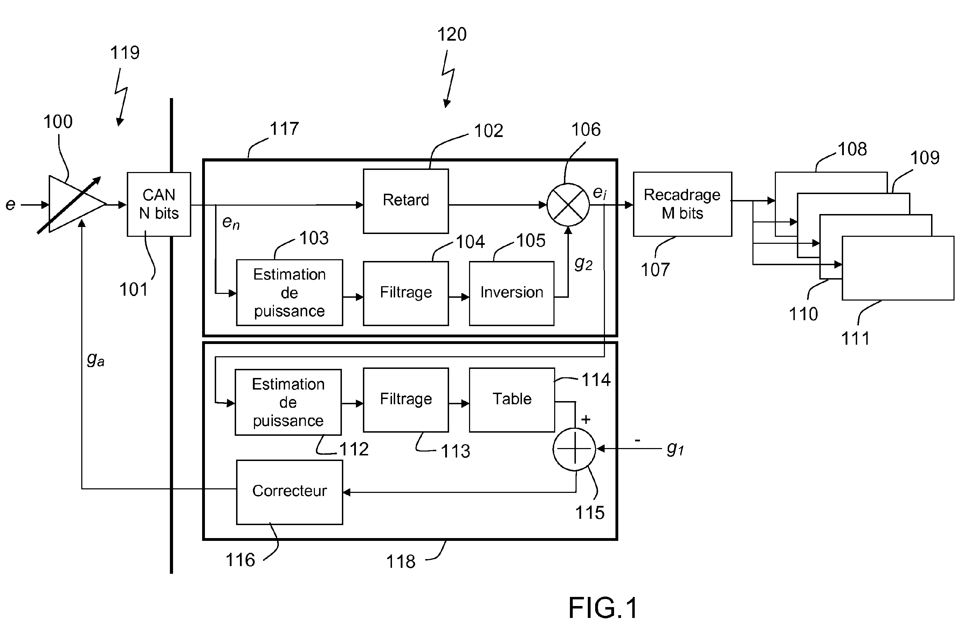

La figure 1 présente un premier mode de réalisation du système de réception selon l'invention. Dans ce mode de réalisation, les traitements réalisés par le système sont répartis sur deux étages, un étage analogique 119 et un étage numérique 120. L'étage analogique 119 comprend notamment un amplificateur à gain variable 100 ayant pour objectif l'amplification d'un signal analogique d'entrée e. Après amplification, le signal est introduit dans un convertisseur CAN 101 sur N bits. Le signal numérisé *eₙ* correspond à une succession d'échantillons numériques codés sur N bits.

Le système selon l'invention comprend un module d'inversion de puissance 117 ayant pour objectif de réduire l'impact des interférences pulsées sur le signal à démoduler. Pour cela, la puissance du signal numérisé *eₙ* est estimée 103. Cette estimation de puissance 103 est réalisée, par exemple, par élévation au carré des échantillons du signal *eₙ*. La puissance estimée est ensuite filtrée 104 en utilisant par exemple un filtre à horizon glissant. La puissance estimée et filtrée est ensuite inversée 105 en utilisant par exemple par une table de correspondance afin de produire un gain d'inversion *g₂*. Ce gain *g₂* est appliqué 106 à une version retardé du signal numérisé *eₙ*, ledit signal étant retardé 102 afin de compenser le retard introduit par le filtre 104. Ces retards sont par exemple de l'ordre de la microseconde. Après application du gain *g₂*, on obtient un signal *eᵢ*.

Afin d'asservir le gain analogique *gₐ* de façon à avoir un rendement maximal du convertisseur CAN, une boucle de contrôle adaptatif de gain CAG 118, appelée aussi boucle de contrôle automatique de gain est utilisée. Le mode de réalisation présenté figure 1 comprend une boucle CAG 118. Cette boucle comporte un module 112 de détermination de la puissance du signal en sortie dudit convertisseur CAN et/ou de la moyenne de cette puissance, un filtre numérique 113, une table de correspondance 114 permettant de passer en échelle logarithmique. L'estimation de puissance 112 est effectué sur le signal *eᵢ* obtenu après application 106 du gain inverse *g₂*.

Le résultat obtenu après estimation de puissance 112, filtrage 113 et conversion 114 est comparé 115 à une consigne de commande *g₁*. La différence entre la puissance mesurée filtrée et la consigne *g₁* est utilisée par un correcteur 116 pour déterminer la valeur du gain analogique *gₐ* à appliquer à l'amplificateur à gain variable 100 de l'étage analogique 119. Le correcteur 116 permet d'appliquer un gain à la différence mentionnée précédemment puis d'alimenter un intégrateur infini, jamais remis à zéro. Le choix de la consigne de commande *g₁* dépend de la valeur du rendement optimal pour la conversion. Le choix du gain de correcteur détermine la constante de temps de la boucle CAG.

Avantageusement, l'inversion de puissance, c'est-à-dire la mise en oeuvre d'une relation d'inversion entre la puissance en entrée et la puissance en sortie, est réalisée dans le domaine temporel. Cela permet de pondérer le signal e qui entre dans le récepteur de manière progressive en fonction de sa qualité et permet à la boucle CAG 118 de s'asservir naturellement sur un niveau de signal reçu proche du niveau plancher correspondant au niveau de bruit de fond hors interférence.

En outre, à la différence de la technique d'annulation temporaire de signal, il n'est plus nécessaire de déterminer a priori un seuil d'annulation pour annuler des portions de signal, ce qui évite le risque de divergence de la boucle CAG en cas de pulses d'interférence trop fréquents.

Les bits en sortie du module d'inversion de puissance 117 peuvent être recadrés 107, c'est-à-dire codés sur un nombre M de bit plus petit, l'opération de recadrage étant habituellement désignée par l'expression anglo-saxonne « bit rescaling ». Le signal ainsi numérisé et recadré est ensuite utilisé pour démoduler les signaux de radionavigation portés par le signal *e* dans les canaux de démodulation 108, 109, 110, 111. A titre d'exemple, les systèmes GNSS utilisent habituellement des signaux large bande générés à bord des satellites en utilisant la technique d'étalement de spectre par code d'étalement modulant une porteuse. Dans ce cas, chaque canal de démodulation du récepteur est associé à un code d'étalement propre à un satellite.

Ainsi, le système selon l'invention limite l'impact des interférences en mettant en oeuvre une inversion de puissance tout en utilisant une boucle CAG modifiée dont le signal d'entrée est pris après application du gain d'inversion de puissance *g₂*.

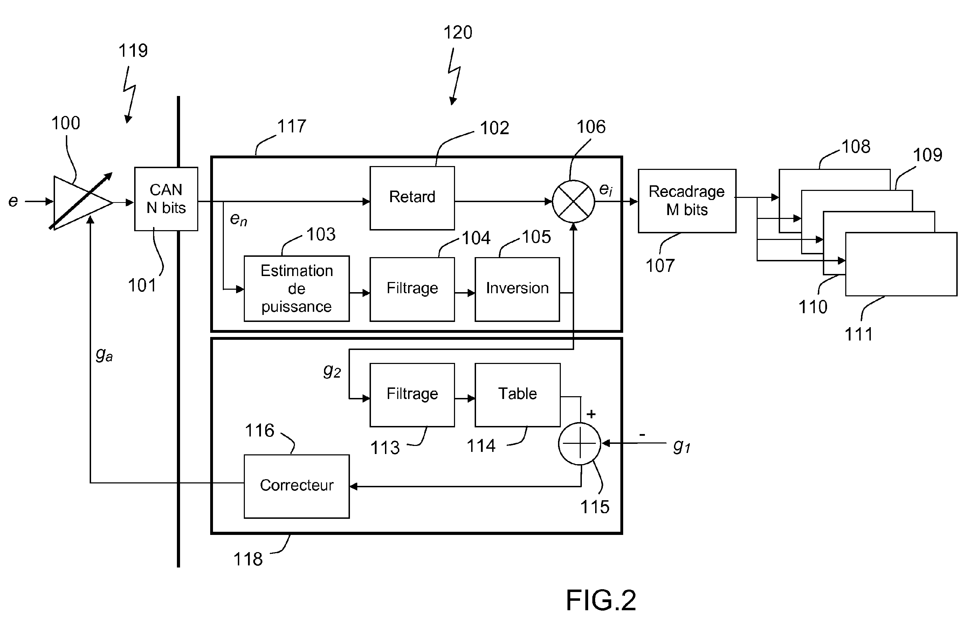

La figure 2 présente un second mode de réalisation du système de réception selon l'invention. Les éléments du système de réception portant la même référence que pour la figure 1 sont identiques.

Ce second mode de réalisation diffère du premier mode de réalisation en ce que le gain d'inversion de puissance *g₂* est utilisé directement en entrée de la boucle CAG. Cela permet d'éviter de calculer la puissance en entrée de ladite boucle et ainsi de simplifier son fonctionnement.

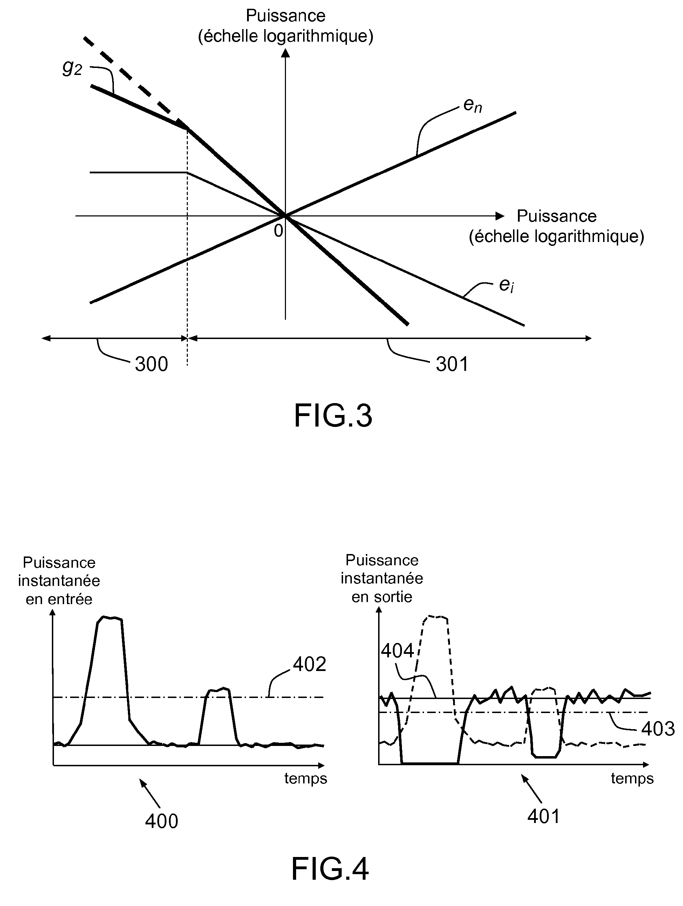

La figure 3 illustre la manière dont le gain d'inversion *g₂* peut être déterminé. Les relations entre les puissances du signal d'entrée numérisé *eₙ*, du signal inversé *eᵢ* et le gain d'inversion *g₂* sont représentées graphiquement, les abscisses et ordonnées représentant des puissances en échelle logarithmique. Avantageusement, la relation entre la puissance du signal numérisé *eₙ* et la puissance du signal inversé *eᵢ* peut être différente selon les valeurs mesurées de la puissance *eₙ*. Ainsi, sur une première plage de puissance 300, un premier profil de gain *g₂* peut être utilisé et sur une seconde plage 301, un second profil de gain *g₂* peut être utilisé. En d'autres termes, la pente du gain d'inversion *g₂* est modifiée afin de limiter la puissance du signal inversé *eᵢ*. A titre d'exemple, sur la première portion 300, une pente -1 en échelle logarithmique est associée au premier profil de *g₂* et sur la seconde portion 301, une pente -2 en échelle logarithmique est associée au second profil de *g₂*. Cette modification de la pente correspond à une modification de la relation entre l'estimation de la puissance du signal *eₙ* et le gain d'inversion *g₂* pour les valeurs les plus faibles, c'est-à-dire pour la première plage 300. Cela est équivalent en échelle linéaire à mettre en oeuvre une loi en racine carrée tabulée après l'inversion de la puissance estimé filtrée.

La figure 4 présente des exemples de mesures de la puissance instantanée avant et après le traitement d'inversion de puissance. Avant inversion de puissance 400, la puissance du signal *eₙ* varie significativement en présence d'interférences pulsées. Ces variations impactent la puissance moyenne estimée 402 utilisée par une boucle CAG classique de l'état de l'art. Il apparaît qu'après l'inversion de puissance 401, le signal *eᵢ* a une puissance moyenne 403 proche de la puissance moyenne du signal 404 que l'on estimerait en absence d'interférence, et que donc la boucle de CAG ne sera pas trop affectée par les pulses d'interférence, du moins jamais au point de la faire diverger.

L'inversion de la puissance entre le signal d'entrée numérisé *eₙ* et le signal après inversion de puissance *eᵢ* signifie que l'on donne proportionnellement plus de poids aux séquences du signal reçu de puissance faible et moins de poids aux séquences du signal reçu de forte puissance. Or la composante du signal reçu comprenant l'information utile est de puissance constante et est noyée dans le bruit et les interférences. Cela qui signifie que là où la puissance totale est faible, la qualité du signal reçu est grande, c'est-à-dire que le rapport signal sur bruit est plus élevé, et inversement. Ainsi, l'invention met en oeuvre une pondération auto-adaptative intelligente.

Le système selon l'invention est beaucoup moins sensible aux défauts de régulation du niveau de signal par la CAG pour ce qui est des performances en rapport signal sur bruit. En effet, il n'y a pas, comme dans le cas de la technique d'annulation temporaire, de seuil fixe à positionner a priori par rapport au niveau de signal plancher, ce dernier pouvant fluctuer à cause des imperfections de la boucle CAG. Le système est donc plus robuste face aux biais éventuels de la boucle CAG dues aux interférences pulsées. En outre la boucle de CAG selon l'invention est moins perturbée par les pulses d'interférences car la puissance moyenne (403) estimée après l'inversion de puissance s'éloigne moins de sa valeur plafond (404) correspondant au bruit de fond. Il n'y a donc plus de risque de faire diverger la CAG au point de rendre la démodulation impossible. En effet dans le calcul de la puissance moyenne (403) après l'inversion de puissance, comme on accorde beaucoup moins de poids aux séquences de signal perturbées, on est plus proche de la puissance moyenne plafond (404) après l'inversion de puissance, que l'on obtiendrait en absence d'interférence et qui correspond au bruit de fond seul.

## Revendications

1. Système de réception d'un signal analogique *e* comprenant :
- des moyens pour amplifier (100) et numériser (101) ledit signal afin d'obtenir un signal numérisé *eₙ*,
- une boucle de contrôle automatique de gain CAG (118) adaptant la puissance du signal *e* avant numérisation,
le système **caractérisé en ce qu'**il comprend en outre:
- un module d'inversion de puissance (117) déterminant un gain d'inversion de puissance *g₂*, ce gain étant appliqué (106) au signal numérisé *eₙ*de manière à obtenir un signal de sortie *eᵢ*dont la puissance est inversement proportionnelle à la puissance de *eₙ,* un signal
d'entrée de la boucle CAG (118) étant fonction du gain d'inversion de puissance *g₂*.

2. Système de réception selon la revendication 1 dans lequel le signal d'entrée de la boucle CAG (118) est le signal *eᵢ* obtenu après application (106) du gain d'inversion de puissance *g₂*.

3. Système de réception selon la revendication 1 dans lequel le signal d'entrée de la boucle CAG (118) est le gain d'inversion de puissance *g₂* déterminé par le module d'inversion.

4. Système de réception selon l'une quelconque des revendications précédentes adapté pour recevoir des signaux satellites de type GNSS.

5. Système de réception selon l'une quelconque des revendications précédentes dans lequel le module d'inversion (117) estime (103) la puissance du signal numérisé *eₙ,* filtre (104) la puissance estimée, inverse (105) la puissance estimée filtrée afin d'obtenir le gain *g₂* appliqué (106) au signal numérisé *eₙ*.

6. Système de réception selon la revendication 5 dans lequel le gain d'inversion *g₂* est appliqué (106) à une version retardé du signal numérisé *eₙ,* ledit signal étant retardé (102) afin de compenser le retard introduit par le filtrage (104).

7. Système de réception selon l'une quelconque des revendications 5 ou 6 dans lequel la relation d'inversion (105) entre la puissance estimé filtrée du signal numérisé *eₙ* et le gain d'inversion *g₂* diffère selon les valeurs mesurées de la puissance *eₙ*.

8. Système de réception selon la revendication 7 dans lequel le gain *g₂* est déterminé à l'aide d'au moins deux profils de gain d'inversion, un profil de gain d'inversion permettant de faire correspondre la puissance du signal numérisé *eₙ* et la puissance du signal inversé *eᵢ*, un premier profil de gain d'inversion *g₂* étant utilisé pour une première plage de valeurs de puissance (300), et un second profil de gain d'inversion *g₂* est utilisé pour une seconde plage de valeurs de puissance (301).

## Patentansprüche

1. System zum Empfangen eines Analogsignals *e,* das Folgendes umfasst:
- Mittel zum Verstärken (100) und Digitalisieren (101) des Signals, um ein digitalisiertes Signal *eₙ* zu erhalten;
- eine AGC-(automatische Verstärkungsregelung)-Schleife (118), die die Leistung des Signals *e* vor der Digitalisierung anpasst,
wobei das System **dadurch gekennzeichnet ist, dass** es ferner Folgendes umfasst:
- ein Leistungsumkehrmodul (117) zum Bestimmen einer Leistungsumkehrverstärkung *g₂*, wobei diese Verstärkung auf das digitalisierte Signal *eₙ* angewandt (106) wird, um ein Ausgangssignal *eᵢ* zu erhalten, dessen Leistung umgekehrt proportional zur Leistung von *eₙ* ist, wobei ein Eingangssignal der AGC-Schleife (118) von der Leistungsumkehrverstärkung *g₂* abhängig ist.

2. Empfangssystem nach Anspruch 1, bei dem das Eingangssignal der AGC-Schleife (118) das Signal *eᵢ* ist, das nach dem Anwenden (106) der Leistungsumkehrverstärkung *g₂* erhalten wird.

3. Empfangssystem nach Anspruch 1, bei dem das Eingangssignal der AGC-Schleife (118) die durch das Umkehrmodul bestimmte Leistungsumkehrverstärkung *g₂* ist.

4. Empfangssystem nach einem der vorherigen Ansprüche zum Empfangen von Satellitensignalen des GNSS-Typs.

5. Empfangssystem nach einem der vorherigen Ansprüche, bei dem das Umkehrmodul (117) die Leistung des digitalisierten Signals *eₙ* schätzt (103), die geschätzte Leistung filtert (104), die gefilterte geschätzte Leistung umkehrt (105), um die auf das digitalisierte Signal *eₙ* angewandte (106) Verstärkung *g₂* zu erhalten.

6. Empfangssystem nach Anspruch 5, bei dem die Umkehrverstärkung *g₂* auf eine verzögerte Version des digitalisierten Signals *eₙ* angewandt (106) wird, wobei das Signal verzögert (102) wird, um die durch die Filterung (104) eingeführte Verzögerung zu kompensieren.

7. Empfangssystem nach Anspruch 5 oder 6, bei dem sich die Umkehrbeziehung (105) zwischen der gefilterten geschätzten Leistung des digitalisierten Signals *eₙ* und der Umkehrverstärkung *g₂* gemäß den gemessenen Werten der Leistung *eₙ* unterscheidet.

8. Empfangssystem nach Anspruch 7, bei dem die Verstärkung *g₂* mit Hilfe von wenigstens zwei Umkehmerstärkungsprofilen bestimmt wird, wobei mit einem Umkehrverstärkungsprofil die Leistung des digitalisierten Signals *eₙ* und die Leistung des invertierten Signals *eᵢ* in Übereinstimmung gebracht werden können, wobei ein erstes Umkehrverstärkungsprofil *g₂* für einen ersten Bereich von Leistungswerten (300) benutzt wird und ein zweites Umkehrverstärkungsprofil *g₂* für einen zweiten Bereich von Leistungswerten (301) benutzt wird.

## Claims

1. A system for receiving an analogue signal *e* comprising:
- means for amplifying (100) and digitising (101) said signal in order to obtain a digitised signal *eₙ*;
- an automatic gain control (AGC) loop (118) adapting the power of the signal *e* before digitisation,
the system being **characterised in that** it further comprises:
- a power inversion module (117) determining a power inversion gain *g₂*, said gain being applied (106) to the digitised signal *eₙ* so as to obtain an output signal *eᵢ*, the power of which is inversely proportional to the power of *eₙ*, an input signal of the AGC loop (118) being a function of the power inversion gain *g₂*.

2. The reception system according to claim 1, wherein the input signal of the AGC loop (118) is the signal *eᵢ* that is obtained after the application (106) of the power inversion gain *g₂*.

3. The reception system according to claim 1, wherein the input signal of the AGC loop (118) is the power inversion gain *g₂* determined by the inversion module.

4. The reception system according to any one of the preceding claims adapted to receive satellite signals of the GNSS type.

5. The reception system according to any one of the preceding claims, wherein the inversion module (117) estimates (103) the power of the digitised signal *eₙ*, filters (104) the estimated power, inverts (105) the filtered estimated power in order to obtain the gain *g₂* that is applied (106) to the digitised signal *eₙ.*

6. The reception system according to claim 5, wherein the inversion gain *g₂* is applied (106) to a delayed version of the digitised signal *eₙ,* said signal being delayed (102) so as to compensate for the delay introduced by the filtering (104).

7. The reception system according to claims 5 or 6, wherein the inversion (105) relation between the filtered estimated power of the digitised signal *eₙ* and the inversion gain *g₂* differs according to the measured values of said power *eₙ.*

8. The reception system according to claim 7, wherein the gain *g₂* is determined using at least two inversion gain profiles, with an inversion gain profile allowing the power of the digitised signal *eₙ* and the power of the inverted signal *eᵢ* to be matched, a first inversion gain *g₂* profile being used for a first range of power values (300) and a second inversion gain *g₂* profile being used for a second range of power values (301).
